# EUROPEAN PATENT APPLICATION

(11) **EP 0 833 204 A1**
(43) Date of publication of application: **01.04.1998**
(21) Application number: 97202899.7
(22) Date of filing: 22.09.1997
(51) Int. Cl.: G03F 7/022, G03F 7/20

(54) **Infrared-sensitive diazonaphthoquinone imaging composition and element**

(30) Priority: 30.09.1996 US 723335; 30.09.1996 US 723176; 08.08.1997 US 907607; 08.08.1997 US 907759
(71) Applicant: EASTMAN KODAK COMPANY, Rochester, New York 14650 (US)
(72) Inventor: West, Paul Richard, Eastman Kodak Company, Rochester, New York 14650-2201 (US); Sheriff, Eugene Lynn, Eastman Kodak Company, Rochester, New York 14650-2201 (US); Gurney, Jeffery Allen, Eastman Kodak Company, Rochester, New York 14650-2201 (US); Schneebeli, Ralph Scott, Eastman Kodak Company, Rochester, New York 14650-2201 (US); Jordan, Thomas Robert, Eastman Kodak Company, Rochester, New York 14650-2201 (US); Miller, Gary Roger, Eastman Kodak Company, Rochester, New York 14650-2201 (US); DoMinh, Thap, Eastman Kodak Company, Rochester, New York 14650-2201 (US)
(74) Representative: Nunney, Ronald Frederick Adolphe

(57) **Abstract**

An infrared radiation sensitive imaging composition contains two essential components, namely an infrared radiation absorbing material, and a phenolic resin that is either mixed or reacted with an *o*-diazonaphthoquinone derivative. These compositions are useful in imaging elements such as lithographic printing plates that can be used to provide either positive or negative images using laser imaging, and that can be adapted to direct-to-plate imaging procedures.

## Description

This invention relates to an imaging composition and element that are sensitive to infrared radiation. In particular, this invention relates to either positive-working or negative-working lithographic printing plates, and to methods of providing images using them.

A widely used type of lithographic printing plate has a light-sensitive coating applied to an aluminum base support. The coating may respond to light by having the portion that is exposed become soluble so that it is removed in the developing process. Such a plate is referred to in the art as a positive-working printing plate. Conversely, when that portion of the coating that is exposed becomes hardened, the plate is referred to as a negative-working plate. In both instances, the image areas remaining are ink-receptive or oleophilic and the non-image areas or background are water-receptive or hydrophilic. The differentiation between image and non-image areas is made in the exposure process where a film is applied to the plate with a vacuum to insure good contact. The plate is then exposed to a light source, a portion of which is composed of UV radiation. In the instance of negative-working plates, the areas on the film corresponding to the image areas are clear, allowing light to harden the image area coating, while the areas on the film corresponding to the non-image areas are black, preventing the light hardening process, so the areas not struck by light can be removed during development. The light-hardened surfaces of a negative-working plate are therefore oleophilic and will accept ink while the non-image areas that have had the coating removed through the action of a developer are desensitized and are therefore hydrophilic.

Various useful printing plates can be either negative-working or positive-working by containing imaging layers containing an *o*-diazonaphthoquinone and a resole resin, and optionally a novolac resin as described in GB-2,082,339. Another plate comprises a phenolic resin and a radiation-sensitive onium salt as described in US-A-4,708,925. This imaging composition can also be used for the preparation of a direct laser addressable printing plate, that is imaging without the use of a photographic transparency.

Direct digital imaging of offset printing plates is a technology that has assumed importance to the printing industry. The first commercially successful workings of such technology made use of visible light-emitting lasers, specifically argon-ion and frequency doubled Nd:YAG lasers. Printing plates with high photosensitivities are required to achieve acceptable through-put levels using plate-setters equipped with practical visible-light laser sources. Inferior shelf-life, loss in resolution and the inconvenience of handling materials under dim lighting are trade-offs that generally accompany imaging systems exhibiting sufficiently high photosensitivities.

Advances in solid-state laser technology have made high-powered diode lasers attractive light sources for plate-setters. Currently, at least two printing plate technologies have been introduced that can be imaged with laser diodes emitting in the infrared regions, specifically at 830 nm. One of these is described in EP 573,091 and in US-A-5,353,705, US-A-5,351,617, US-A-5,379,698, US-A-5,385,092 and US-A-5,339,737. This technology relies upon ablation to physically remove the imaging layer from the printing plate. Ablation requires high laser fluences, resulting in lower through-puts and problems with debris after imaging.

A higher speed and cleaner technology is described, for example, in US-A-5,340,699, US-A-5,372,907, US-A-5,466,557 and EP-A-0 672 954 which uses near-infrared energy to produce acids in an imagewise fashion. These acids catalyze crosslinking of the coating in a post-exposure heating step. Precise temperature control is required in the heating step. The imaging layers in the plates of US-A-5,372,907 comprise a resole resin, a novolac resin, a latent Bronsted acid and an infrared absorbing compound. Other additives, such as various photosensitizers, may also be included.

DE-4,426,820 describes printing plates that can be imaged in the near infrared at moderate power levels with relatively simple processing requirements. One embodiment of the printing plate has at least two layers: an imaging layer containing an *o*-diazonaphthoquinone compound and an infrared absorbing compound, and a protective overcoat containing a water-soluble polymer or silicone polymer. Another embodiment has a single layer. Both plates are floodwise exposed with ultraviolet light to convert the *o*-diazonaphthoquinone to an indenecarboxylic acid, which is then imagewise decarboxylated by means of heat transferred from the infrared absorbing material. Development with an alkaline solution results in removal of areas not subjected to thermal decarboxylation. The pre-imaging floodwise exposure step, however, is awkward in that it precludes the direct loading of the printing plates into plate-setters.

Thus, there is a need for printing plates that can be easily imaged in the near infrared at moderate power levels and require relatively simple processing methods.

The problems noted above with known photosensitive compositions and printing plates are overcome with an imaging composition having as a first essential component:
(i) a mixture of a phenolic resin and an *o*-diazonaphthoquinone derivative,
(ii) a reaction product of a resin and an *o*-diazonaphthoquinone reactive derivative, or
(iii) a mixture of (i) and (ii)
the composition characterized as further containing a material that absorbs infrared radiation having a maximum absorption wavelength greater than 700 nm as the only other essential component of the composition.

This invention also provides an imaging element consisting essentially of a support having thereon an imaging layer that is characterized as consisting essentially of the imaging composition described above. In preferred negative-working elements, the imaging layer is the outermost layer. That is, there is no protective outer layer.

The compositions and elements of this invention can be either positive-working or negative-working.

Thus, this invention provides a method for imaging an element described above in a negative-working fashion, comprising:
A) providing the imaging element described above,
B) without prior or simultaneous floodwise exposure to actinic radiation, imagewise exposing the element with an infrared radiation emitting laser,
C) floodwise exposing the element, and
D) contacting the element with an aqueous developing solution to remove the non-image areas of the imaging layer.

In another embodiment, the invention provides a method for imaging an element described above in a positive-working fashion, comprising:
A) providing the imaging element described above,
B) without prior or simultaneous floodwise exposure to actinic radiation, imagewise exposing the element with an infrared radiation emitting laser, and
C) contacting the element with an aqueous developing solution to remove the image areas of the imaging layer.

The imaging composition and element of this invention are useful for providing high quality digital negative or positive images using moderately powered lasers. In the method of providing a negative image, laser imaging need not be preceded by floodwise exposure to actinic radiation. In other words, in contrast to the nagative-working imaging process described in DE 4,426,820, the photosensitive *o*-diazonaphthoquinone need not be converted to the corresponding indenecarboxylic acid prior to laser imaging. This makes the imaging element much more convenient to use in plate-setters. Any convenient floodwise exposure means can then be used after digital imaging if desired to provide a negative image. The floodwise exposure can be omitted entirely to provide a positive image. The element of this invention also does not need a protective overcoat for either type of image, thereby eliminating the materials and coating step required for such layers. However, a protective overcoat is optimal for the elements used to provide positive-working images.

Since the elements of this invention are infrared sensitive, digital imaging information can be conveniently utilized to form continuous or halftone images using the moderately powered laser diodes. Moreover, the imaging composition is also sensitive to ultraviolet light, thereby making it sensitive to radiation from two distinct regions of the spectrum. In other words, it can be exposed at two different wavelengths.

As noted above, the imaging composition of this invention contains only two essential components a) and b):
a) either
   (i) a mixture of a phenolic resin and an *o*-diazonaphthoquinone derivative,
   (ii) a reaction product of a resin and an *o*-diazonaphthoquinone reactive derivative, or
   (iii) a mixture of (i) and (ii), and
b) a compound that absorbs infrared radiation having a maximum absorption wavelength greater than 750 nm.

The resins useful in the practice of this invention to form a reaction product with an *o*-diazonaphthoquinone reactive derivative can be any type of resin that has a suitable reactive group for participating in such a reaction. For example, such resins can have a reactive hydroxy or amino group. The phenolic resins defined below are most preferred, but other resins include copolymers of acrylates and methacrylates with hydroxy-containing acrylates or methacrylates, as described for example in US-A-3,859,099, for example, a copolymer of hydroxyethyl methacrylate and methyl methacrylate. Still other useful resins include copolymers of styrene (or styrene derivatives) with aminostyrenes, as described for example in US-A-3,759,711, for example, a copolymer of styrene and p-aminostyrene.

The phenolic resins useful herein are light-stable, water-insoluble, alkali-soluble film-forming resins that have a multiplicity of hydroxy groups either on the backbone of the resin or on pendant groups. The resins typically have a molecular weight of at least 350, and preferably of at least 1000, as determined by gel permeation chromatography. An upper limit of the molecular weight would be readily apparent to one skilled in the art, but practically it is 100,000. The resins also generally have a pKa of not more than 11 and as low as 7.

As used herein, the term "phenolic resin" includes, but is not limited to, what are known as novolac resins, resole resins and polyvinyl compounds having phenolic hydroxy groups. Novolac resins are preferred.

Novolac resins are generally polymers that are produced by the condensation reaction of phenols and an aldehyde, such as formaldehyde, or aldehyde-releasing compound capable of undergoing phenol-aldehyde condensation, in the presence of an acid catalyst. Typical novolac resins include, but are not limited to, phenol-formaldehyde resin, cresol-formaldehyde resin, phenol-cresol-formaldehyde resin, *p*-*t*-butylphenol-formaldehyde resin, and pyrogallol-acetone resins. Such compounds are well known and described for example in US-A-4,308,368, US-A-4,845,008, US-A-5,437,952 and US-A-5,491,046, US-A-5,143,816 and GB 1,546,633. A particularly useful novolac resin is prepared by reacting *m*-cresol or phenol with formaldehyde using conventional conditions.

Another useful phenolic resin is what is known as a "resole resin" that is a condensation product of bis-phenol A and formaldehyde. One such resin is commercially available as UCAR phenolic resin BKS-5928 from Georgia Pacific Corporation.

Still another useful phenolic resin is a polyvinyl compound having phenolic hydroxyl groups. Such compounds include, but are not limited to, polyhydroxystyrenes and copolymers containing recurring units of a hydroxystyrene, and polymers and copolymers containing recurring units of halogenated hydroxystyrenes. Such polymers are described for example in US-A-4,845,008. Other hydroxy-containing polyvinyl compounds are described in US-A-4,306,010 and US-A-4,306,011 which are prepared by reacting a polyhydric alcohol and an aldehyde or ketone, several of which are described in the patents. Still other useful phenolic resins are described in US-A-5,368,977.

A mixture of the resins described above can be used, but preferably, a single novolak resin is present in the imaging composition of this invention.

When the imaging composition of this invention is formulated as a coating composition in suitable coating solvents, the resin is present in an amount of at least 0.5 weight percent. Preferably, it is present in an amount of from 1 to 10 weight percent.

In the dried imaging layer of the element of this invention, the resin is the predominant material. Generally, it comprises at least 25 weight percent of the layer, and more preferably, it is from 60 to 90 weight percent of the dried layer.

In one embodiment of this invention, a phenolic resin is present in admixture with an *o*-diazonaphthoquinone derivative. Such compounds comprise an *o*-diazonaphthoquinone moiety attached to a ballasting moiety that has a molecular weight of at least 15, but less than 5000.

Such derivatives have at least one *o*-diazonaphthoquinone group in the molecule, and which is made more soluble in an alkali solution upon irradiation with actinic light. Such derivatives are prepared from compounds that are well known in the art, including those described, for example in Kosar, Light-Sensitive System, John Wiley & Sons Inc., 1965, such as esters or amides with a suitable aromatic polyhydroxy compound or amine. Examples are esters of 2-diazo-1,2-dihydro-1-oxonaphthalenesulfonic acid or carboxylic acid chlorides.

Useful derivatives include, but are not limited to:
2,4-bis(2-diazo-1,2-dihydro-1-oxo-5-naphthalenesulfonyloxy)benzophenone,
2-diazo-1,2-dihydro-1-oxo-5-naphthalenesulfonyloxy-2,2-bis hydroxyphenylpropane monoester,
the hexahydroxybenzophenone hexaester of 2-diazo-1,2-dihydro-1-oxo-5-naphthalenesulfonic acid,
2,2'-bis(2-diazo-1,2-dihydro-1-oxo-5-naphthalenesulfonyloxy)biphenyl,
2,2',4,4'-tetrakis(2-diazo-1,2-dihydro-1-oxo-5-naphthalenesulfonyloxy)biphenyl,
2,3,4-tris(2-diazo-1,2-dihydro-1-oxo-5-naphthalenesulfonyloxy)benzophenone,
2,4-bis(2-diazo-1,2-dihydro-1-oxo-4-naphthalenesulfonyloxy)benzophenone,
2-diazo-1,2-dihydro-1-oxo-4-naphthalenesulfonyloxy-2,2-bis(hydroxyphenyl)propane monoester,
the hexahydroxybenzophenone hexaester of 2-diazo-1,2-dihydro-1-oxo-4-naphthalenesulfonic acid,
2,2'-bis(2-diazo-1,2-dihydro-1-oxo-4-naphthalenesulfonyloxy)biphenyl,
2,2',4,4'-tetrakis(2-diazo-1,2-dihydro-1-oxo-4-naphthalenesulfonyloxy)biphenyl,
2,3,4-tris(2-diazo-1,2-dihydro-1-oxo-4-naphthalenesulfonyloxy)benzophenone, and
others known in the art, for example described in US-A-5,143,816 (noted above).

The weight ratio of phenolic resin to *o*-diazonaphthoquinone derivative in this embodiment is generally at least 0.5:1, and a weight ratio of from 2:1 to 6:1 is preferred.

In another and preferred embodiment of this invention, a reaction product of a resin (as described above) and an *o*-diazonaphthoquinone reactive derivative is used in the imaging composition. Such a derivative has a functional group (such as chloride or reactive imide group) that can react with a suitable reactive group (for example, a hydroxy group) of the resin (such as a phenolic resin) and thereby become part of the resin, rendering the resin sensitive to light. The reactive group can be in the 4- or 5-position of the *o*-diazonaphthoquinone molecule.

Representative reactive compounds include sulfonic and carboxylic acid, ester or amide derivatives of the *o*-diazonaphthoquinone moiety. Preferred compounds are the sulfonyl chloride or esters, and the sulfonyl chlorides are most preferred. Reactions with the phenolic resins are well known in the art, being described for example in GB 1,546,633, US-A-4,308,368 and US-A-5,145,763.

Whether in admixture or reacted with a resin, the amount of *o*-diazonaphthoquinone moiety in the dried imaging composition is generally at least 1 weight percent, and more preferably from 3 to 50 weight percent. A mixture of different *o*-diazonaphthoquinone derivatives or reactive derivatives can be used in the same composition, but preferably, only a single derivative is used.

The second essential component of the imaging composition of this invention is an infrared radiation absorbing material (or IR absorbing material), or mixture thereof. Such materials typically have a maximum absorption wavelength (λₘₐₓ) in the region of at least 700 nm, that is in the infrared region and near infrared of the spectrum, and more particularly, from 800 to 1100 nm. The materials can be dyes or pigments, a wide range of which are well known in the art (including US-A-4,912,083, US-A-4,942,141, US-A-4,948,776, US-A-4,948,777, US-A-4,948,778, US-A-4,950,639, US-A-4,950,640, US-A-4,952,552, US-A-4,973,572, US-A-5,036,040 and US-A-5,166,024). Classes of materials that are useful include, but are not limited to, squarylium, croconate, cyanine (including phthalocyanine), merocyanine, chalcogenopyryloarylidene, oxyindolizine, quinoid, indolizine, tellurium, oxonol, thiopyrillium, pyrylium and metal dithiolene dyes or pigments. Other useful classes include thiazine, azulenium and xanthene dyes. Particularly useful infrared absorbing dyes are of the cyanine class. Carbon and carbon black can be used in place of a dye, or in admixture therewith, if desired.

The amount of infrared radiation absorbing material in the dried imaging layer is generally sufficient to provide an optical density of at least 0.05 in the layer, and preferably, an optical density of from 1 to 3. This range would accommodate a wide variety of materials having vastly different extinction coefficients. Generally, this is at least 0.1 weight percent, and preferably from 5 to 25 weight percent.

However, when certain nitrogen-containing, basic dyes are used as the infrared radiation absorbing materials, the amounts used can determine whether the imaging composition is positive- or negative-working. At weight ratios of the infrared radiation-absorbing material to the diazonaphthoquinone of less than 1:14, the composition will be positive-working. Preferably, such weight ratios are from 1:50 to 1:330. Higher ratios provide a negative-working composition. Such infrared radiation-absorbing materials are those generally having any of the following basic groups shown in US-A-5,631,119: 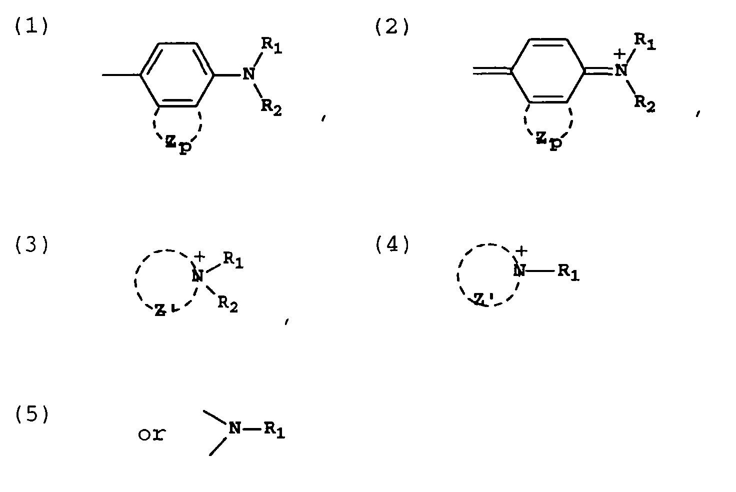 wherein R₁ and R₂ are independently hydrogen, alkyl of 1 to 20 carbon atoms (branched or linear), alkoxy of 1 to 20 carbon atoms (branched or linear), alkaryl of 7 to 20 carbon atoms, aralkyl of 7 to 20 carbon atoms or aryl of 6 to 14 carbon atoms. Any of these groups can be substituted with one or more groups that would be readily apparent to one skilled in the art. Z and Z' independently represent the carbon, nitrogen, oxygen and sulfur atoms necessary to complete a 6 to 20 atom cyclic group, and p is 0 or 1.

In one embodiment, non-basic infrared radiation absorbing materials having a maximum IR absorption wavelength greater than 700 nm, can be used to provide positive-working imaging compositions and elements. Such non-basic infrared radiation absorbing materials include carbon black, a tellurium dye, an oxonol dye, a thiopyrilium dye, a cyanine dye or a squarilium dye, as the predominant (more than 50 weight % of total absorbing materials) infrared radiation absorbing material (or "IR absorbing material"), as long as such materials are "non-basic" as defined herein. Preferably no other infrared absorbing material is present. The tellurium dyes and carbon black are preferred and carbon black is most preferred. This IR absorbing material must have a maximum IR absorption wavelength (that is λₘₐₓ) greater than 700 nm, preferably from 750 to 1400 nm. Mixtures of such IR absorbing materials can be used if desired.

By one definition, "non-basic" material is an IR absorbing material that is incapable of substantially deprotonating indenecarboxylic acids. In particular, the non-basic material does not contain a basic nitrogen atom such as in an amino or imino group, or a nitrogen-containing heterocyclic ring. For example, the IR absorbing dyes specifically defined in US-A-5,631,119 (noted above) are excluded from use in this positive-working embodiment because they contain at least one basic nitrogen atom. More specifically, such non-basic IR absorbing materials do not contain any of the following moieties described in Structures (1) - (5) noted above.

Representative examples of useful non-basic IR absorbing materials include, but are not limited to, carbon black,
8-[5-[6,7-dihydro-2,4-bis[4-(pentyloxy]phenyl]-5H-1-benzopyran-8-yl]-2,4-pentadienylidene]-5,6,7,8-tetrahydro-2,4-diphenyl-1-benzopyrylium perchlorate,
8-[5-(6,7-dihydro-6-methyl-2,4-diphenyl-5H-1-benzopyran-8-yl)-2,4-pentadienylidene]-5,6,7,8-tetrahydro-6-methyl-2,4-diphenyl-1-benzopyrylium perchlorate,
8-[[3-[(6,7-dihydro-2,4-diphenyl-5H-1-benzopyran-8-yl)methylene]-1-cyclohexen-l-yl]methylene]-5,6,7,8-tetrahydro-2,4-diphenyl-1-benzopyrylium perchlorate,
7-[3-(5,6-dihydro-2,4-diphenylcyclopenta[b]thiopyran-7-yl)-2-propenylidene]-6,7-dihydro-2,4-diphenyl-5H-cyclopenta[b]thiopyrylium perchlorate,
8-[[3-[(6,7-dihydro-2,4-diphenyl-5H-1-benzopyran-8-yl)methylene]-2-methyl-1-cyclohexen-1-yl]methylene]-5,6,7,8-tetrahydro-2,4-diphenyl-1-benzopyrylium perchlorate,
8-[[3-[(6,7-dihydro-2,4-diphenyl-5H-1-benzopyran-8-yl)methylene]-2-phenyl-1-cyclohexen-1-yl]methylene]-5,6,7,8-tetrahydro-2,4-diphenyl-1-benzopyrylium tetrafluoroborate,
4-[2-[3-[(2,6-diphenyl-4H-thiopyran-4-ylidene)ethylidene]-2-phenyl-1-cyclohexen-1-yl]ethenyl]-2,6-diphenyl-thiopyrylium perchlorate,
4-[2-[3-[(2.6-diphenyl-4H-thiopyran-4-ylidene)ethylidene]-2-phenyl-1-cyclopenten-1-yl]ethenyl]-2,6-diphenyl-thiopyrylium perchlorate,
4-[2-[2-chloro-3-[(2-phenyl-4H-1-benzothiopyran-4-ylidene)ethylidene]-1-cyclohexen-1-yl]ethenyl]-2-phenyl-1-benzothiopyrylium perchlorate,
dyes disclosed in US-A-4,508,811, especially 1,3-bis[2,6-di-*t*-butyl-4H-thiopyran-4-ylidene)methyl]-2,4-dihydroxy-dihydroxide-cyclobutene diylium-bis(inner salt) and 1,3-bis(2,4-di-*t*-butyl-4H-pyran-4-ylidene)methyl-2,4-dihydroxy-dihydroxide-cylobutene diylium-bis{inner salt},
N,N,N-tributyl-1-butanaminium bis [3,4,6-trichloro-1,2-benzenedithiolato(2-)-S,S']nickelate(1-),
4-[3-[2,6-bis(1,1-dimethylethyl)-4H-tellurin-4-ylidene]-1-propenyl]-2,6-bis(1,1-dimethylethyl)tellurium tetrafluoroborate,
some of the squarilium and croconylium dyes disclosed in US-A-5,405,976, especially the dye referred to as "Ir1",
and the oxonol dyes disclosed in EP 444,786.

Optional, non-essential components of the imaging composition include colorants, sensitizers, stabilizers, exposure indicators, dissolution accelerators, and surfactants in conventional amounts. In preferred embodiments, a surfactant (such as silicone material) may be present.

The imaging composition is coated out of one or more suitable organic solvents that have no effect on the sensitivity of the composition. Various solvents for this purpose are well known, but acetone and 1-methoxy-2-propanol are preferred. The essential components of the composition are dissolved in the solvents in suitable proportions.

Suitable conditions for drying the imaging composition involve heating for a period of time of from 0.5 to 5 minutes at a temperature in the range of from 20 to 150 °C.

To form an imaging element of this invention, the imaging composition is applied (usually by coating techniques) onto a suitable support, such as a metal, polymeric film, ceramics or polymeric-coated paper using conventional procedures and equipment. Suitable metals include aluminum, zinc or steel, but preferably, the metal is aluminum. A most preferred support is an electrochemically grained and sulfuric acid anodized aluminum sheet that has been further treated with an acrylamide-vinylphosphonic acid copolymer according to the teaching in US-A-5,368,974. Such elements are generally known as lithographic printing plates, but other useful elements include printed circuit boards.

The thickness of the resulting imaging layer, after drying, on the support can vary widely, but typically it is in the range of from 0.5 to 2 µm, and preferably from 1 to 1.5 µm.

No other essential layers are provided on the element of this invention. It is preferred that there are no protective or other type of layers over the imaging layer, but such layer may be used in certain instances. Optional, but not preferred subbing or antihalation layers can be disposed under the imaging layer, or on the backside of the support (such as when the support is a transparent polymeric film).

The elements of this invention are uniquely adapted for "direct-to-plate" imaging applications. Such systems utilize digitized image formation, as stored on a computer disk, compact disk, computer tape or other digital information storage media, or information that can be provided directly from a scanner, that is intended to be printed. The bits of information in a digitized record correspond to the image elements or pixels of the image to be printed. This pixel record is used to control the exposure device, that is a modulated laser beam. The position of the laser beam can be controlled using any suitable means known in the art, and turned on and off in correspondence with pixels to be printed. The exposing beam is focused onto the unexposed imaging element of this invention. Thus, no exposed and processed films are needed for imaging of the elements, as in the conventional lithographic imaging processes.

Laser imaging can be carried out using any moderate or high-intensity laser diode writing device. Specifically, a laser printing apparatus is provided that includes a mechanism for scanning the write beam across the element to generate an image without ablation. The intensity of the write beam generated at the laser diode source at the element is at least 10 milliwatts/µm² (preferably 10-1000 milliwatts/µm²). During operation, the element to be exposed is placed in the retaining mechanism of the writing device and the write beam is scanned across the element to generate an image.

Following laser imaging, to provide a negative image, the element of this invention can be subjected to floodwise (or complete) exposure to a suitable ultraviolet or other actinic light source. This irradiation converts the *o*-diazonaphthoquinone moiety of the photosensitive layer into the corresponding indenecarboxylic acid. Irradiation can be achieved using any suitable source of ultraviolet radiation including carbon arc lamps, mercury vapor lamps, fluorescent lamps, tungsten filament lamps and photoflood lamps. The level of exposure is usually at least 10 millijoules/cm². Such exposure sources can include units designed for use with lithographic plate processors.

To provide a positive image, no floodwise exposure is used after laser imaging.

Lastly, the element is then developed (with or without floodwise exposure) in an alkaline developer solution until the non-image areas (or image areas) are removed to provide the desired negative (or positive) image. Development can be carried out under conventional conditions for from 30 to 120 seconds. One useful aqueous alkaline developer solution is a silicate solution containing an alkali metal silicate or metasilicate. Such a developer solution can be obtained from Eastman Kodak Company as KODAK PRODUCTION SERIES Machine Developer/Positive.

After development, the element can be treated with a finisher such as gum arabic.

After laser imaging and development, the imaging elements are suitable for printing on a wide variety of substrates, using conventional techniques.

The following examples are provided to illustrate the practice of this invention, and not to limit it in any manner. Unless otherwise noted, all percentages are by weight.

### Example 1:

An imaging coating formulation was prepared as follows:

| **COMPONENT** | **PARTS** |
|---|---|
| Cresol-formaldehyde novolac resin | 2.585 |
| 2,4-Bis(2-diazo-1,2-dihydro-1-oxo-5-naphthalenesulfonyloxy)benzophenone | 1.551 |
| 2-[2-[2-chloro-3-[(1,3-dihydro-1,1,3-trimethyl-2H-benz[e]indol-2-ylidene)ethylidene-1-cyclohexen-1-yl]ethenyl]-1,1,3-trimethyl-1H-benz[e]indolium, salt with 4-methylbenzenesulfonic acid IR absorbing dye | 0.620 |
| CG 21-1005 dye colorant | 0.103 |
| BYK 307 polyether-modified polydimethylsiloxane from BYK-Chemie | 0.010 |
| Acetone solvent | 4.043 |
| 1-Methoxy-2-propanol solvent | 91.087 |

This formulation was applied to give a dry coating weight of 1 g/m² onto electrochemically grained and sulfuric acid anodized aluminum sheets that had been further treated with an acrylamide-vinylphosphonic acid copolymer (according to US-A-5,368,974, noted above) to form unexposed lithographic printing plates.

Two of these plates (A and B) were imaged with a 500 milliwatt diode laser emitting a modulated pulse centered at 830 nm. Plate A was then given a 7.5 unit flood-exposure with an Olec exposure unit in the high intensity mode and processed with KODAK PRODUCTION SERIES Machine Developer/P to provide a high resolution negative image. Plate B was similarly imaged and processed with the flood exposure increased to 15 units. Fine highlight dots were again retained after processing to provide a negative image. The optical density of the processed coating, as determined by reflectance, was 0.80 compared with 0.83 for Plate A, indicating wide latitude with respect to the flood exposure dose.

### Example 2:

A different imaging coating formulation was prepared like that in Example 1 except that an equal amount of 2-diazo-1,2-dihydro-1-oxo-5-naphthalenesulfonyloxy-2,2-bis(hydroxyphenyl) propane monoester was used in place of 2,4-bis(2-diazo-1,2-dihydro-1-oxo-5-naphthalenesulfonyloxy)benzophenone. The formulation was used to prepare a lithographic printing plate as noted above.

The plate was imaged at energies of 225 and 550 millijoules/cm² with a 500 milliwatt diode laser emitting a modulated pulse centered at 830 nm, flood exposed with 15 units from an Olec exposure unit mode and developed as described in Example 1, to reveal a high resolution negative image.

### Example 3:

Example 2 was repeated except that an equal amount of hexahydroxybenzophenone hexaester of 2-diazo-1,2-dihydro-1-oxo-5-naphthalenesulfonic acid (available from Toyo Gosei) was used in place of 2-diazo-1,2-dihydro-1-oxo-5-naphthalenesulfonyloxy-2,2-bis(hydroxyphenyl)propane monoester. A high resolution negative image was obtained by processing the resulting lithographic printing plate.

### Example 4:

An imaging coating formulation of this invention was prepared using a cresol-formaldehyde resin (purchased from Schenectady Chemical Company) derivatized with 2-diazo-1,2-dihydro-1-oxo-5-naphthalenesulfonyl chloride (5.3 parts), the Example 1 IR absorbing dye (0.7 part), and 1-methoxy-2-propanol solvent (94.0 parts).

This formulation was used to prepare a lithographic printing plate that was imaged and processed as described in Example 2 to provide a high resolution negative image.

### Example 5:

An imaging coating formulation of this invention was prepared using a poly(4-hydroxystyrene) resin (purchased from Hoescht-Celanese Company) derivatized with 2-diazo-1,2-dihydro-1-oxo-5-naphthalenesulfonyl chloride (5.3 parts), the Example 1 IR absorbing dye (0.7 part), and 1-methoxy-2-propanol solvent (94.0 parts).

This formulation was used to prepare a lithographic printing plate that was imaged and processed as described in Example 2 to provide a high resolution negative image.

### Example 6:

An imaging coating formulation of this invention was prepared using a cresol-formaldehyde resin (purchased from Schenectady Chemical Co.) derivatized with 2-diazo-1,2-dihydro-1-oxo-4-naphthalenesulfonyl chloride (5.3 parts), the Example 1 IR absorbing dye (0.7 part), and 1-methoxy-2-propanol solvent (94.0 parts).

This formulation was used to prepare a lithographic printing plate that was imaged and processed as described in Example 2 to provide a high resolution negative image.

This formulation was similarly coated on a poly(ethylene terephthalate) film support that had been modified with a hydrophilic titanium dioxide layer (5.14 g/m² TiO₂ in 1.58 g/m² gelatin) and similarly imaged and processed to provide a high resolution negative image.

### Example 7:

An imaging coating formulation of this invention was prepared using a mixture of the derivatized resins of Example 4 and 6 (2.65 parts for each), the Example 1 IR absorbing dye (0.7 part), and 1-methoxy-2-propanol solvent (94.0 parts).

This formulation was used to prepare a lithographic printing plate that was imaged and processed as described in Example 2 to provide a high resolution negative image.

The resulting printing plate was mounted on a conventional printing press and used to produce at least 40,000 copies of the desired image without any degradation of the plate image, despite conditions designed to accelerate plate wear.

### Example 8:

A positive-working imaging composition was prepared as follows:

| **COMPONENT** | **GRAMS** |
|---|---|
| Cresol-formaldehyde novolac resin | 42.273 |
| Diester of 2-diazo-1,2-dihydro-1-oxo-5-naphthalenesulfonate and 2,3,4-trihydroxybenzophenone | 7.128 |
| IR absorbing dye* | 0.599 |
| 1-Methoxy-2-propanol solvent | 950 |

| | |
|---|---|
| *IR dye is 2-(2-(2-chloro-3-((1,3-dihydro-1,1,3-trimethyl-2H-benz(e)indol-2-ylidene)ethylidene)-1- cyclohexen-1-yl)ethenyl)-1,1,3-trimethyl-III-benz(e)indolium, salt with 4-methylbenzenesulfonic acid. | |

This formulation was applied to give a dry coating weight of about 120 g/m² onto electrochemically grained and sulfuric acid anodized aluminum sheets that had been further treated with an acrylamide-vinylphosphonic acid copolymer (according to US-A-5,368,974, noted above) to form an unexposed lithographic printing plate.

The plate was imaged with a 500 milliwatt diode laser emitting a modulated pulse centered at 830 nm. The plate was then processed with KODAK PRODUCTION SERIES Machine Developer/Positive to provide a high resolution positive image.

### Example 9:

A second imaging composition of this invention was prepared using a cresol-formaldehyde novolac resin (purchased from Schenectady Chemical Company) derivatized (at 3%) with 2-diazo-1,2-dihydro-1-oxo-5-naphthalenesulfonyl chloride (45.259 grams of derivatized resin), the IR absorbing dye of Example 8 (0.626 grams), diester of 2-diazo-1,2-dihydro-1-oxo-5-naphthalenesulfonyloxy and 2,3,4-trihydroxybenzophenone (4.115 grams)and 1-methoxy-2-propanol solvent (950 grams).

This formulation was used to prepare a lithographic printing plate that was imaged and processed as described in Example 8 to provide a high resolution positive image.

### Example 10:

Still another imaging composition of this invention was prepared using a cresol-formaldehyde novolac resin (purchased from Schenectady Chemical Company) derivatized (at 6%) with 2-diazo-1,2-dihydro-1-oxo-5-naphthalenesulfonyl chloride (49.374 grams of derivatized resin), the IR absorbing dye of Example 8 (0.626 grams), diester of 2-diazo-1,2-dihydro-1-oxo-5-naphthalenesulfonyloxy and 2,3,4-trihydroxybenzophenone (4.115 grams) and 1-methoxy-2-propanol solvent (950 grams).

This formulation was used to prepare a lithographic printing plate that was imaged and processed as described in Example 8 to provide a high resolution positive image.

### Example 11:

An imaging composition of this invention was prepared using a cresol-formaldehyde novolac resin (purchased from Schenectady Chemical Co.) derivatized (3 %) with 2-diazo-1,2-dihydro-1-oxo-4-naphthalenesulfonyl chloride (45.3 grams of derivatized resin), the IR absorbing dye of Example 8 (0.626 grams), and 1-methoxy-2-propanol solvent (950 grams).

This formulation was used to prepare a lithographic printing plate that was imaged and processed as described in Example 8 to provide a high resolution positive image.

### Example 12:

An imaging coating formulation was prepared as follows:

| **COMPONENT** | **GRAMS** |
|---|---|
| Cresol-formaldehyde novolac resin | 4.940 |
| 2,4-Bis(2-diazo-1,2-dihydro-1-oxo-5-naphthalenesulfonyloxy)benzophenone | 0.833 |
| Carbon black | 0.033 |
| 1-Methoxy-2-propanol solvent | 82.888 |
| Acetone | 11.195 |
| CG-21-1005 | 0.100 |
| BYK-307 | 0.011 |
| CG 21-1005 is a dye available from Ciba-Geigy. BYK-307 is a polyether-modified polydimethylsiloxane available from BYK-Chemie. | |

This formulation was applied to give a dry coating weight of about 1 g/m² onto electrochemically grained and sulfuric acid anodized aluminum sheets that had been further treated with an acrylamide-vinylphosphonic acid copolymer (according to US-A-5,368,974) to form an unexposed lithographic printing plate.

The plate was imaged on a Gerber 42/T platesetter and then processed with KODAK PRODUCTION SERIES Machine Developer/Positive to provide a well-defined positive image. This example shows that the present invention can provide a useful positive image at low concentrations of IR absorbing material.

### Example 13:

Two imaging coating formulations were prepared with the following components:

| **COMPONENT** | **Control A** | **Example 2** |
|---|---|---|
| *m*-Cresol-formaldehyde novolac resin derivatized with 2-diazo-1,2-dihydro-1-oxo-5-naphthalenesulfonyl chloride | 4.338 | 4.338 |
| 2-{2-[2-chloro-3-((1,3-dihdyro-1,13-trimethyl-2H-benz[e]indol-2-ylidene)ethylidene)-1-cyclohexene-1-yl]ethenyl}-1,1,3-trimethyl-1H-benz[e]indolium, salt with 4-methylbenzenesulfonic acid | 0.651 | 0 |
| Carbon black | 0 | 0.651 |
| 1-Methoxy-2-propanol solvent | 94.892 | 85.000 |
| CG-21-1005 | 0.108 | 0 |
| BYK-307 | 0.011 | 0.011 |
| CG 21-1005 is a dye available from Ciba-Geigy. BYK-307 is a polyether-modified polydimethylsiloxane available from BYK-Chemie. | | |

These two formulations were coated to form lithographic printing plates as described in Example 12. The plate was then overcoated with an aqueous solution of poly(vinyl alcohol) to a dry coating coverage of about 2 g/m².

The Control A plate was imaged with a 500 mW diode laser emitting a modulated pulse centered at 830 nm, followed by a 15 unit floodwise exposure with an Olec exposure unit in the high intensity mode and processed as described in Example 12. The Control A plate produced a negative image.

One half of the Example 13 plate was floodwise exposed as noted above. Both halves of the plate were then imaged with the IR laser as described above. The half of the plate that had not been previously floodwise exposed was then floodwise exposed. The plate provided positive images on both halves of the plate after processing as described above. This example demonstrates that substitution of the "basic" IR absorbing material in Control A with carbon black in Example 13 transforms the IR sensitive coating from one that is negative-working to one that is positive-working. Moreover, Example 13 remained positive-working whether floodwise exposed before or after IR laser imaging, and is positive-working. Moreover, additional layers do not affect the imaging properties.

### Examples 14-17:

Four imaging compositions and plates of the present invention were prepared using the following components:

| **COMPONENT** | **Example 14 (grams)** | **Example 15 (grams)** | **Example 16 (grams)** | **Example 17 (grams)** |
|---|---|---|---|---|
| Cresol-formaldehyde novolac resin | 4.620 | 4.620 | 4.620 | 4.620 |
| 2,4-Bis(2-diazo-1,2-dihydro-1-oxo-5-naphthalenesulfonyloxy)benzo-phenone | 1.154 | 1.154 | 1.154 | 1.154 |
| Carbon black | 0.108 | 0.217 | 0.434 | 0.868 |
| 1-Methoxy-2-propanol solvent | 88.118 | 88.009 | 87.792 | 87.358 |
| Acetone | 5.881 | 5.881 | 5.881 | 5.881 |
| CG-21-1005 | 0.108 | 0.108 | 0.108 | 0.108 |
| BYK-307 | 0.011 | 0.011 | 0.011 | 0.011 |
| CG 21-1005 is a dye available from Ciba-Geigy. BYK-307 is a polyether-modified polydimethylsiloxane available from BYK-Chemie. | | | | |

Each formulation was used to prepare a plate as described in Example 12, and the plates were imaged using a Gerber 42/T platesetter at 1064 nm and also on a CREO 3244 Thermal platesetter at 830 nm. The plates were then developed as described in Example 12 to produce positive images. These examples illustrate that the present invention provides positive images over a wide range of IR absorbing material, and that the plates can be imaged over a broad portion of the near infrared region of the electromagnetic spectrum.

### Example 18:

An imaging coating formulation was prepared as follows:

| **COMPONENT** | **GRAMS** |
|---|---|
| *m*-Cresol-formaldehyde novolac resin derivatized with 2-diazo-1,2-dihydro-1-oxo-5-naphthalenesulfonyl chloride | 4.442 |
| 2,4-Bis(1,2-naphthoquinone-2-diazido-5-sulfonyloxy)benzo-phenone | 0.774 |
| Carbon black | 0.347 |
| 1-Methoxy-2-propanol solvent | 94.318 |
| CG-21-1005 | 0.108 |
| BYK-307 | 0.011 |
| CG 21-1005 is a dye available from Ciba-Geigy. BYK-307 is a polyether-modified polydimethylsiloxane available from BYK-Chemie. | |

This formulation was coated as described in Example 12, given a series of exposures on a Gerber 42/T platesetter, and then developed as described in Example 12. From a graphical plot of remaining thickness versus imaging dose, it was determined that the minimum imaging dose to clear for the positive-working was 300 mJ/cm².

### Example 19:

An imaging coating formulation was prepared as follows:

| **COMPONENT** | **GRAMS** |
|---|---|
| *m*-Cresol-formaldehyde novolac resin derivatized with 2-diazo-1,2-dihydro-1-oxo-5-naphthalenesulfonyl chloride | 4.472 |
| 2,4-Bis(1,2-naphthoquinone-2-diazido-5-sulfonyloxy)benzo-phenone | 0.490 |
| FC-430 | 0.013 |
| Carbon black | 0.350 |
| 1-Methoxy-2-propanol solvent | 94.409 |
| CG-21-1005 | 0.109 |
| BYK-307 | 0.026 |
| CG 21-1005 is a dye available from Ciba-Geigy. BYK-307 is a polyether-modified polydimethylsiloxane available from BYK-Chemie. FC-430 is a fluorinated surfactant available from 3M. | |

This formulation was coated at a coverage of about 1.4 g/m², imaged and developed as described in Example 12 to produce a strong visible positive image. The plate was then mounted on a commercially available printing press and successfully used to print the image on paper.

### Example 20:

The following imaging composition was prepared and coated on aluminum substrates as described in Example 12:

| **COMPONENT** | **GRAMS** |
|---|---|
| *m*-Cresol-formaldehyde novolac resin derivatized with 2-diazo-1,2-dihydro-1-oxo-5-naphthalenesulfonyl chloride | 3.934 |
| Carbon black | 0.437 |
| 1-Methoxy-2-propanol solvent | 95.51 |
| CG-21-1005 | 0.108 |
| BYK-307 | 0.011 |
| CG 21-1005 is a dye available from Ciba-Geigy. BYK-307 is a polyether-modified polydimethylsiloxane available from BYK-Chemie. | |

The resulting plates were imagewise exposed using a commercially available CREO 3244 Thermal platesetter at 11 watts, 64 rpm, and then subjected to floodwise exposure using a commercially available Olec exposure apparatus at several exposure levels, 5, 10, 20 and 30 exposure units.

Following exposure, the plate was developed using a 2:1 dilution of a developer solution similar to that described in Example 12. It was observed that the plate exposed at the 30 unit exposure level provided a definite negative image, while the plate exposed at the 5 unit exposure level provided a positive image. The plates exposed at the intermediate levels exhibited poor image discrimination. It is believed that, in view of this teaching, imaging compositions could of this invention can be formulated to be either positive- or negative-working. Preferably, however, the compositions are more readily formulated to be positive-working.

### Example 21:

An imaging coating formulation was prepared as follows:

| **COMPONENT** | **GRAMS** |
|---|---|
| 2,4-Bis(2-diazo-1,2-dihydro-1-oxo-5-naphthalenesulfonyloxy)benzophenone | 0.75 |
| *m*-Cresol-formaldehyde novolac resin derivatized with 2-diazo-1,2-dihydro-1-oxo-5-naphthalenesulfonyl chloride | 4.31 |
| 4,6-Dimethyl-N,N'-diphenyl-1,3-benzenesulfonamide | 0.43 |
| Tellurium dye as the infrared absorbing compound- see below | 0.52 |
| Acetone | 93.39 |
| CG-21-1005 | 1.01 |
| BYK-307 | 0.13 |
| CG 21-1005 is a dye available from Ciba-Geigy. BYK-307 is a polyether-modified polydimethylsiloxane available from BYK-Chemie. | |

The tellurium dye used in this formulation has the structure:

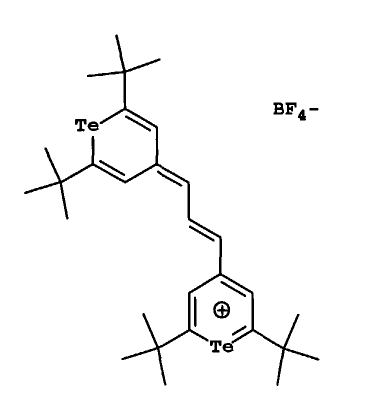

The formulation was coated as in Example 12 to give a dry coating weight of about 1.1 g/m². The resulting plate was dried for 3 minutes at 82 °C, and imagewise exposed to a diode laser (830 nm) at a dose of 350-600 mJ/cm². The plate was then developed as described in Example 12 to provide a very good positive image.

### Example 22:

Example 21 was repeated using a tellurium dye having the same structure but with a chloride anion. The resulting IR-imaged and developed printing plate provided a desired positive image.

## Claims

1. An imaging composition having as a first essential component:
(i) a mixture of a phenolic resin and an *o*-diazonaphthoquinone derivative,
(ii) a reaction product of a resin and an *o*-diazonaphthoquinone reactive derivative, or
(iii) a mixture of (i) and (ii),
the composition characterized as further containing a material that absorbs infrared radiation having a maximum absorption wavelength greater than 700 nm as the only other essential component of the composition.

2. The composition as claimed in claim 1 wherein the composition has as the first essential component, the reaction product (ii) wherein the resin is a phenolic resin.

3. The composition as claimed in either claim 1 or 2 wherein the phenolic resin is a novolac resin.

4. The composition as claimed in any of claims 1 to 3 wherein the *o*-diazonaphthoquinone reactive derivative is a sulfonic acid or carboxylic acid ester of *o*-diazonaphthoquinone.

5. The composition as claimed in any of claims 1 to 4 wherein the *o*-diazonaphthoquinone derivative is 2,4-bis(2-diazo-1,2-dihydro-1-oxo-5-naphthalenesulfonyloxy)benzophenone, 2-diazo-1,2-dihydro-1-oxo-5-naphthalenesulfonyloxy-2,2-bis(hydroxyphenyl)propane monoester, the hexahydroxybenzophenone hexaester of 2-diazo-1,2-dihydro-1-oxo-5-naphthalenesulfonic acid, 2,2'-bis(2-diazo-1,2-dihydro-1-oxo-5-naphthalenesulfonyloxy)biphenyl, 2,2',4,4'-tetrakis(2-diazo-1,2-dihydro-1-oxo-5-naphthalenesulfonyloxy)biphenyl, 2,3,4-tris(2-diazo-1,2-dihydro-1-oxo-5-naphthalenesulfonyloxy)benzophenone, 2,4-bis(2-diazo-1,2-dihydro-1-oxo-4-naphthalenesulfonyloxy)benzophenone, 2-diazo-1,2-dihydro-1-oxo-4-naphthalenesulfonyloxy-2,2-bis hydroxyphenylpropane monoester, the hexahydroxybenzophenone hexaester of 2-diazo-1,2-dihydro-1-oxo-4-naphthalenesulfonic acid, 2,2'-bis(2-diazo-1,2-dihydro-1-oxo-4-naphthalenesulfonyloxy)biphenyl, 2,2',4,4'-tetrakis(2-diazo-1,2-dihydro-1-oxo-4-naphthalenesulfonyloxy)biphenyl or 2,3,4-tris(2-diazo-1,2-dihydro-1-oxo-4-naphthalenesulfonyloxy)benzophenone.

6. The composition as claimed in any of claims 1 to 5 wherein the infrared radiation absorbing material is a squarylium, croconate, cyanine, merocyanine, indolizine, pyrylium or metal dithiolene dye or pigment that absorbs infrared radiation at a wavelength of from 800 to 1100 nm, and is present in an amount sufficient to provide an optical density of at least 0.5.

7. The composition as claimed in any of claims 1 to 5 wherein the infrared radiation absorbing material is a non-basic material.

8. The composition as claimed in claim 7 wherein the non-basic infrared-radiation absorbing material is carbon black, or a tellurium, thiopyrillium, oxonol, cyanine or squarilium dye.

9. An imaging element consisting essentially of a support having thereon an imaging layer formed from the imaging composition as claimed in any of claims 1 to 8.

10. A lithographic imaging element consisting essentially of a grained and anodized aluminum support having thereon a single layer comprising an imaging composition that is characterized as consisting essentially of a reaction product of a phenol-formaldehyde novolak resin and 2-diazo-1,2-dihydro-1-oxo-4 or -5-naphthalenesulfonyl chloride, and carbon black or a cyanine dye that absorbs infrared radiation having a wavelength of from 800 to 1100 nm.

11. A method for imaging an imaging element in a negative-working fashion comprising:
A) providing the imaging element as claimed in any of claims 9 or 10,
B) without prior or simultaneous floodwise exposure to actinic radiation, imagewise exposing the element with an infrared radiation emitting laser,
C) floodwise exposing the element, and
D) contacting the element with an aqueous developing solution to remove the non-image areas of the imaging layer.

12. A method for imaging an imaging element in a positive-working fashion comprising:
A) providing the imaging element as claimed in any of claims 9 or 10,
B) without prior or simultaneous floodwise exposure to actinic radiation, imagewise exposing the element with an infrared radiation emitting laser, and
C) contacting the element with an aqueous developing solution to remove the image areas of the imaging layer.

13. The use of the imaging element of claim 9 or 10, after laser exposure, for printing.
